# EUROPEAN PATENT APPLICATION

(11) **EP 4 838 007 A1**
(43) Date of publication of application: **11.11.2026**
(21) Application number: 25382472.6
(22) Date of filing: 09.05.2025
(51) Int. Cl.: D21H 19/20, B32B 29/00, B65D 35/42, D21H 19/84, D21H 27/10

(54) **A MULTI-LAYER PACKAGING MATERIAL FOR WRAPPING FATTY PRODUCTS, A PACKAGE AND A METHOD FOR MANUFACTURING THE MUTI-LAYER PACKAGING MATERIAL**

(71) Applicant: Torraspapel, S.A.U., 08019 Barcelona (ES)
(72) Inventor: MARTÍNEZ ESPARZA, Javier, 08019 Barcelona (ES); LAÍNEZ JIMÉNEZ, Sara, 08019 Barcelona (ES)
(74) Representative: Elion IP, S.L.

(57) **Abstract**

The disclosure refers to a multi-layer packaging material for wrapping fatty products comprising, from its outermost side to its innermost side, the following layers: a post-metallization coating layer comprising a mixture of nitrocellulose, acrylic and polyurethane polymers in solvent medium; a vacuum deposited metallization layer; a pre-metallization layer, comprising one or more coating layers; a cellulose-based material layer having a grammage from 60 to 90 g/m²; an intermediate coating layer, the intermediate coating layer comprising acrylic polymeric emulsions, polyurethanes and/or sulfopolyesters; and an inner coating layer, the inner coating layer comprising acrylic copolymeric emulsions.

## Description

### TECHNICAL FIELD

The present disclosure relates to the field of multi-layer packaging materials. More particularly, the present disclosure relates to a multi-layer packaging material for wrapping fatty products, such as butters, margarines or cheeses, among others, that comprises a cellulose-based material layer, a pre-metallization layer, a metallization layer, a post-metallization coating layer, an intermediate coating layer, and an inner polymeric coating layer. The present disclosure further relates to a package suitable for containing fatty products that is made with the multi-layer packaging material and to a method for manufacturing the multi-layer packaging material, and to a fatty product wrapped with said package.

### BACKGROUND

The packaging of fatty, oily or greasy substances and materials and, in particular, of fatty, oily and greasy foods such as butter, margarine and some kind of cheeses, demands specific materials that present grease barrier properties. For instance, products such as butter or other fats are typically wrapped in different kinds of grease-resistant papers. The resistance to grease of these papers is often enhanced by using composite laminate materials that include some layers made of aluminum and/or polyethylene. Specifically, these laminate materials are made of layers of paper and foil, where aluminum is further combined with materials like wax, paraffin, or polyethylene to create an effective barrier. While aluminum foil is an effective wrapping option for butter and margarine, it is relatively costly and raises environmental concerns.

Another problem associated with the composite laminate materials that include some layers made of aluminum and/or polyethylene is that these foil and/or polymer layers are thick enough, so they represent a high percentage in mass of the composite laminate materials, to make these materials unrecyclable by conventional recycling processes.

Some other grease-resistant papers have been incorporating fluorinated substances in some of their layers to improve the oil barrier properties of the multi-layer packaging materials. However, these fluorinated substances present some environmental and health problems. Recent studies have pointed out some of the health risks that these substances may pose and there exist health directives in some countries that recommend and even prohibit their use in the food industry.

Wrapping materials for fatty products must possess specific characteristics in addition to a high resistance to fats and grease. For example, a strong oxygen barrier is crucial to prevent oxidation, especially for fatty products like butter, margarine, or soft cheeses, thus avoiding rancidity.

Additionally, an important feature of these wrap films is their dead-fold capacity, which allows for crisp, clean edges on the finished package. A reliable dead-fold ensures the material retains its shape during the forming and filling processes, making paper with integrated barrier technology a preferred choice.

Another problem associated with the wrapping of butter or margarine is that in order to fill the wrapping with the butter or margarine, butters and margarines are heated until a semifluid state is reached so they can be easily handled and introduced into the wrapping. For example, butter is heated until it reaches 14°C so that it can be introduced into the wrapping which has been previously wrapped and folded to form a partially closed wrap. This semifluid state of the butter or margarine facilitates their introduction, and the filling of the space defined by the wrap. However, this presents the problem that when the fatty materials are heated to reach a semifluid state they may release some amount of water that travels towards the interface between the wrap and the fatty material. This problem, which is particularly significant in the case of salted butter and salted margarine, turns yellow the outer surface of the butter or margarine block.

Thus, there is a need in the state of the art for multi-layer packaging materials especially designed for wrapping fatty products, such as butter, margarine or soft cheeses, that exhibit an improved barrier against greases but also against oxygen and humidity to avoid their oxidation and thus their rancidity. Besides, it would be desirable that said multi-layer packaging materials, in particular when they are for wrapping salted butters and margarines, to incorporate some mechanism for adsorbing the water that these butters and margarines may release during the wrapping process, so their yellowing is avoided.

### DESCRIPTION

A first aspect of the disclosure refers to a multi-layer packaging material for wrapping fatty products comprising, from its outermost side to its innermost side: a post-metallization coating layer comprising a mixture of nitrocellulose, acrylic and polyurethane polymers in solvent medium; a vacuum deposited metallization layer; a pre-metallization layer, comprising one or more coating layers; a cellulose-based material layer having a grammage from 60 to 90 g/m²; an intermediate coating layer, the intermediate coating layer comprising acrylic polymeric emulsions, polyurethanes and/ or sulfopolyesters; and an inner coating layer, the inner polymeric layer comprising acrylic copolymeric emulsions.

As used herein, the expression "fatty products" may refer to products having at least a 25% fat content, preferably at least a 30% fat content, more preferably at least a 40% fat content, and even more preferably at least a 50% fat content. Examples of fatty products may be salted and unsalted butters (having about 80% fat content), salted and unsalted margarines (having about 70% fat content) and cheeses having at least a 30% fat content like cream cheese, Cheddar cheese, Gruyere cheese, Colby cheese, etc.

As used herein, the outermost side of the multi-layer packaging material refers to the surface outside the packaging and the innermost side of the multi-layer packaging material refers to the surface in contact with the product to be enclosed in the package made with the multi-layer packaging material.

This multi-layer packaging material, having the intermediate coating layer made of acrylic polymeric emulsions, polyurethanes and/or sulfopolyesters and the inner coating layer made of acrylic copolymeric emulsions, this inner coating layer being the layer indirect contact with the wrapped fatty product, provides an improved barrier against fats and grease at the same time that avoids using fluorinated products, in particular perfluorooctanoic acids (PFOAs) and perfluorooctane sulfonates (PFOS), also known as perfluoroalkyl and polyfluoroalkyl substances (PFAS), that are potentially hazardous to the health of consumers and that are banned in some countries. In addition, the use of these layers made of the cited materials facilitates recycling the multi-layer packaging material. Accordingly, in several embodiments a multi-layer packaging material as described herein is free of PFOAs, PFOS, and PFAS, and more in particular is free of any perfluorinated components and more in particular is free of any fluorinated components.

The cellulose-based material layer may be a paper-based layer, a cardboard-based layer, a regenerated cellulose-based layer, a cellophane-based layer, or any other layer made of a cellulose-based material. Preferably, the cellulose-based material layer may have a grammage from 60 to 90 g/m², and more preferably from 65 to 80 g/m². Such grammages provide an adequate balance between strength and flexibility to the layer.

The specific material or combination of materials, thickness, roughness, porosity, etc., of the cellulose-based material layer can be selected to provide an adequate balance between mechanical resistance (tensile strength, elasticity, flexibility, etc.) and surface properties. This balance will be further selected to optimize the deposition of the subsequent coating layers that will provide the barrier properties to the multi-layer packaging material. Both surfaces of the cellulose-based material layer may be subjected to treatments or coatings to make said surfaces smoother and/or more flexible. Additionally, the coating (e.g., a latex-based coating) applied to the outer surface of the cellulose-based material layer (the printing surface) may be different from the coating applied to the inner surface of the cellulose-based material layer, the latter having, e.g., a greater amount of latex. The cellulose-based material layer may be further selected to have a tensile strength in a range from 6 to 9 Kg/15 mm.

In some embodiments, the pre-metallization layer comprises at least one primer coating layer comprising a mixture of nitrocellulose, acrylic and polyurethane polymers in solvent medium or a mixture of acrylic emulsions and acrylic styrene polymeric dispersions. This at least one primer coating layer facilitates the adhesion of the vacuum deposited metallization layer, which is generally made of aluminum, and provides adequate flexibility, good adhesion between layers and good printing properties with various inks, including the most common inks such as solvent inks and UV-curable flexo inks. This primer coating layer, together with the vacuum deposited metallization coating layer and the post-metallization coating layer, also provides an improved water vapour barrier (<50 g/m²·day at 38°C and 90% relative humidity) and adequate light barrier properties (optical density>2).

The combination of this at least one primer coating layer with the intermediate coating layer made of acrylic polymeric emulsions, polyurethanes and/or sulfopolyesters and the inner coating layer made of acrylic copolymeric emulsions provides improved oil barrier properties and water vapour barrier properties and makes the multi-layer packaging material suitable and adequate for wrapping fatty products at the same time that avoids using materials that may pose a health risk such as fluorinated materials.

In some embodiments, the primer coating layer can be present in an amount from 0.6 to 1.5 g/m². Preferably, the primer coating layer can be present in an amount from 0.8 to 1.1 g/m².

In some embodiments, the pre-metallization layer comprises at least one tie coating layer comprising sulfopolyesters or a mixture of elastomeric polyurethanes and nitrocellulose and at least one barrier coating layer comprising a polyvinyl alcohol (PVA) polymer. In such embodiments, the at least one tie coating layer is arranged onto the cellulose-based material layer and the at least one barrier coating layer is arranged between the tie coating layer and the vacuum deposited metallization layer. This tie coating layer facilitates the adhesion of the barrier coating layer and protects it from humidity that may come from the inside of the package by presenting improved water vapour barrier properties.

In some embodiments, the polyvinyl alcohol (PVA) polymer of the barrier coating layer is selected from: unmodified polyvinyl alcohol (PVA); ethylene vinyl alcohol (EVOH) copolymer; butanediol vinyl alcohol (BVOH) copolymer; and combinations thereof.

The combination of this at least one tie coating layer and the at least one barrier coating layer with the intermediate coating layer made of acrylic polymeric emulsions, polyurethanes and/or sulfopolyesters and the inner coating layer made of acrylic copolymeric emulsions provides even better oxygen barrier properties, oil barrier properties and water vapour barrier properties than the solution that combines the at least one primer coating layer with the intermediate and inner coating layers. Thus, this combination of layers allows extending the shelf life of the wrapped fatty product and ensures that the product is kept in optimal conditions for a longer period of time.

In some embodiments, the tie coating layer is present in an amount from 0.3 to 2 g/m². Preferably, the tie coating layer can be present in an amount from 0.5 to 1 g/m².

In some embodiments, the barrier coating layer is present in an amount from 0.5 to 4 g/m². Preferably, the barrier coating layer can be present in an amount from 1.5 to 3 g/m².

In some embodiments, the post-metallization coating layer is present in an amount from 0.6 to 1.5 g/m². Preferably, the post-metallization coating layer can be present in an amount from 0.8 to 1.1 g/m². A post-metallization coating layer thinner than 0.6 g/m² will cause problems during printing by weakening the adhesion between layers. A post-metallization coating layer thicker than 1.5 g/m² could spoil the metallized appearance as the solvent attacks this thin layer.

In some embodiments, the post-metallization coating layer comprises an inner post-metallization coating sublayer deposited onto the vacuum deposited metallization layer and an outer post-metallization coating sublayer deposited onto the inner post-metallization coating sublayer. The inner post-metallization coating sublayer comprises a polyester solution, a mixture of elastomeric polyurethanes and nitrocellulose or acrylic emulsions and the outer post-metallization coating sublayer comprises a mixture of nitrocellulose, acrylic and polyurethane polymers in solvent medium.

In some embodiments, the inner post-metallization coating sublayer is present in an amount from 0.5 to 1.5 g/m² and the outer post-metallization coating sublayer is present in an amount from 0.6 to 1.5 g/m². Preferably, the outer post-metallization coating layer can be present in an amount from 0.8 to 1.2 g/m². This inner post-metallization coating sublayer improves oxygen barrier properties and facilitates the subsequent commercial printing.

In some embodiments, the intermediate coating layer is present in an amount from 1.5 to 4 g/m². Preferably, the intermediate coating layer can be present in an amount from 2 to 3 g/m² which provides enough barrier to grease and moisture and improves the efficiency and recyclability of the material.

In some embodiments, the inner coating layer is present in an amount from 1 to 4 g/m². Preferably, the inner coating layer can be present in an amount from 2 to 3 g/m².

In some embodiments, the inner coating layer comprises an inorganic filler. This inorganic filler is preferably amorphous silica, although other fillers such as aluminum oxide, zeolites or precipitated calcium carbonates could be used instead of or in combination. Amorphous silica is a safe material with a high absorption capacity due to its high porosity. The amorphous silica may have an average particle size that ranges from 1 to 6 micrometers, and more preferably from 2 to 5 micrometers. The particle size is known by the supplier of the amorphous silica and may be determined by means known in the art. For instance, the average particle size may be defined as the median particle size by volume distribution, also referred to as the volume x50 or Dv50 particle size as determined by laser diffraction methods (e.g., using a Mastersizer device) following a standard method such as ASTM E3340-22, by measuring the particle size of the material dispersed in water at room temperature (e.g., 23 °C). By using these particle sizes, an adequate size with respect to the thickness of the coating is achieved to ensure sufficient absorption capacity while maintaining the appropriate oil and water barrier properties. Preferably, the weight ratio of acrylic copolymeric emulsions to inorganic filler ranges from 7:3 to 3:7, preferably from 5:5 to 3:7. This inorganic filler presents a high water adsorption ratio so its presence in this layer that is in direct contact with the wrapped fatty product is especially convenient for adsorbing the water released by the butter or margarine, in particular the salted butter or margarine, during the filling of the wrap when the butter and margarine are in a semisolid state.

In some embodiments, the surface of the cellulose-based material layer on which the intermediate coating layer is deposited has a Parker Print Surf (PPS) roughness value from 0.9 to 1.8 µm; and/or the surface of the cellulose-based material on which the pre-metallization layer is deposited has a Parker Print Surf (PPS) roughness value from 0.9 to 4.5 µm. The PPS roughness is sometimes called printing roughness because it correlates well to the print quality of printing applied to the material in question. The PPS roughness may be measured according to the Dr. John Parker method using a PPS tester as established in, e.g., part 4 of the ISO standard 8791-4:2021 directed to paper and board determination of roughness/smoothness (air leak methods).

In some embodiments, the acrylic polymeric emulsions, if present, are selected from copolymeric acrylic emulsions, styrenated acrylic polymer emulsions; the polyurethane dispersions, if present, are selected from water-based polyurethane dispersions and the sulfopolyesters, if present, are selected from water-based sulfopolyesters dispersions.

In some particular embodiments, the intermediate coating layer comprises acrylic styrene polymeric emulsions, acrylic copolymer emulsions, and/or water-based polyurethane dispersions.

In some embodiments, the vacuum deposited metallization layer is made of aluminum, aluminum oxide (AlOₓ) and/or silicon oxide (SiOₓ). The vacuum deposited metallization also provides barrier properties to oxygen and water vapour (e.g., reduced OTR and VWTR). This metallization layer may be deposited on top of the intermediate coating layer by physical vapor deposition process, e.g., a vacuum deposition process. Vacuum deposition is an evaporative process in which a metal or metal oxide from a solid phase is transferred to the vapor phase and back to the solid phase, gradually building up film thickness. Coatings produced by vacuum deposition have the advantage of having high impact and temperature resistance, as well as the capability to be deposited on complex surfaces and with very low coating thicknesses.

In some embodiments, the vacuum deposited metallization layer has a thickness from 20 to 80 nm, and preferably from 30 to 60 nm. However, the thickness of the vacuum deposited metallization layer may be adjusted, being even greater or smaller than in the previous given ranges, for example, depending on the intended shelf life of the multi-layer packaging material, the type of product to be packaged and the overall thickness of the multi-layer packaging material.

In some embodiments, the vacuum deposited metallization layer may have an equivalent optical density (O.D.) in the range from 2 to 4. The equivalent optical density is a measure of total light transmission through the material and may be determined by the following equation: $O . D . = - Log \left(\frac{{T}_{r}}{{T}_{total}}\right)$ Being 'Tᵣ' the amount of light transmitted through the material and 'Tₜₒₜₐₗ' the total light before getting to the material.

A second object of the present disclosure is a package for wrapping fatty products comprising the multi-layer packaging material previously described. These fatty products can be butters, margarines or soft cheeses. More particularly, these fatty products can be any product having at least a 25% fat content, preferably at least a 30% fat content, more preferably at least a 40% fat content, and even more preferably at least a 50% fat content.

A third object of the present disclosure is a method for manufacturing a muti-layer packaging material for wrapping fatty products, the method comprising the steps of:
providing a cellulose-based material layer having a grammage from 60 to 90 g/m²;
depositing, by a dispersion coating technique, a pre-metallization layer on an outer surface of the cellulose-based material layer, the pre-metallization layer comprising one or more coating layers;
depositing, by a vacuum deposition technique, a metallization layer onto the pre-metallization layer;
depositing, by a dispersion coating technique, a post-metallization layer onto the metallization layer, the post-metallization layer comprising a mixture of nitrocellulose, acrylic and polyurethane polymers in solvent medium;
depositing, by a dispersion coating technique, an intermediate layer on an inner surface of the cellulose-based material layer, the intermediate coating layer comprising acrylic polymeric emulsions, polyurethanes and/or sulfopolyesters; and
depositing, by a dispersion coating technique, an inner layer onto the intermediate layer, the inner layer comprising acrylic copolymeric emulsions.

In some embodiments, the step of depositing a pre-metallization layer comprises depositing a primer layer on the outer surface of the cellulose-based material layer, the primer layer comprising a mixture of nitrocellulose, acrylic and polyurethane polymers in solvent medium or a mixture of acrylic emulsions and acrylic styrene polymeric dispersions.

In some embodiments, the step of depositing a pre-metallization layer comprises:
depositing, by a dispersion coating technique, at least one tie layer comprising sulfopolyesters or a mixture of elastomeric polyurethanes and nitrocellulose, the at least one tie layer being deposited onto the cellulose-based material layer; and
depositing, by a dispersion coating technique, at least one barrier layer comprising a polyvinyl alcohol (PVA) polymer onto the at least one tie layer.

In some embodiments, the step of depositing a post-metallization layer comprises:
depositing, by a dispersion coating technique, an inner post-metallization sublayer onto the metallization layer, the inner post-metallization sublayer comprising a polyester solution, a mixture of elastomeric polyurethanes and nitrocellulose or acrylic emulsions; and
depositing, by a dispersion coating technique, an outer post-metallization sublayer onto the inner post-metallization sublayer, the outer post-metallization sublayer comprising a mixture of nitrocellulose, acrylic polymers and polyurethanes in solvent medium.

The pre-metallization layers, including the tie layer, the primer layer and the barrier layer, the post-metallization layers, including the inner and outer sublayers, the intermediate layer and the inner layer may be typically deposited using dispersion coating techniques such as forward and reverse gravure coating, bar coating and curtain coating, among- others. Accordingly, such layers may also be referred to as dispersion coating layers in the multi-layer packaging material. Thanks to the use of polymer dispersion coating, the overall thickness of polymer material in the whole multi-layer packaging material is low when compared to the thickness of the cellulose-based material layer. Thus, the low thickness obtained by means of the dispersion coating of polymers avoids high cohesion and high adhesion of the polymer to the cellulose, and therefore makes it possible for the multi-layer packaging material to be recycled using, e.g., conventional recycling paper techniques.

The solution herein disclosed presents some advantages over other existing solutions. The multi-layer packaging material herein disclosed provides improved barrier properties, in particular fat and grease barrier properties, for packaging fatty products such as butters, margarines and soft cheeses. This multi-layer packaging material can also be easily recycled with paper recycling process of the state of the art. For example, the multi-layer packaging material may be recycled with other paper packaging and non-packaging materials such as paper recycling process of the state of the art. The water absorption is improved in its innermost layers, which are in contact with the fatty product, to avoid yellowing of butters and margarines, especially when the butters and margarines are salted.

As used herein, the terms "comprise", "comprising", and similar terms, are not to be interpreted in an exclusive or exhaustive sense. In other words, they are intended to mean "including, but not limited to". However, these terms also encompass specific embodiments that "consist of" the elements they anticipate.

### BRIEF DESCRIPTION OF THE DRAWINGS

To complete the description and in order to provide for a better understanding of the disclosure, a set of drawings is provided. Said drawings form an integral part of the description and illustrate an example of the disclosure, which should not be interpreted as restricting the scope of the disclosure, but just as an example of how the disclosure can be carried out.

The drawings comprise the following figures:
Figure 1 shows a schematic representation of a multi-layer packaging material for fatty products, according to an embodiment of the disclosure.
Figure 2 shows a schematic representation of the multi-layer packaging material for fatty products of Figure 1, including a tie coating layer and a barrier coating layer, according to another embodiment of the disclosure.
Figure 3 shows a schematic representation of the multi-layer packaging material for fatty products of Figure 1, including a primer coating layer and an inner and outer coating sublayers, according to another embodiment of the disclosure.
Figure 4 shows a schematic representation of the multi-layer packaging material for fatty products of Figure 2, including a tie coating layer, a barrier coating layer, and an inner and outer coating sublayers, according to another embodiment of the disclosure.
Figure 5 shows a flow diagram of a method for manufacturing the multi-layer packaging material for fatty products, according to an embodiment of the disclosure.

### DESCRIPTION OF EXAMPLES

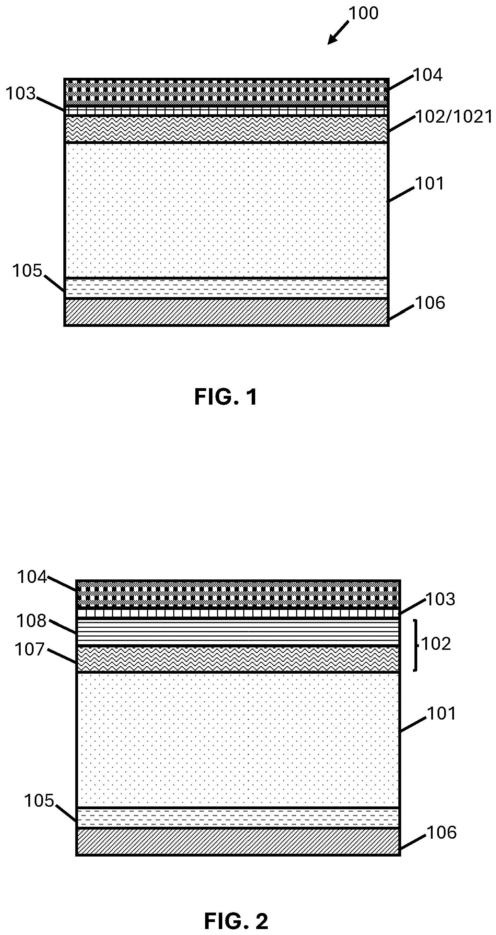

Figure 1 shows a schematic representation of a multi-layer packaging material 100 for fatty products, according to an embodiment of the disclosure. It should be understood that the multi-layer packaging material 100 depicted in Figure 1 may include additional materials and/or components and that some of the materials and/or components described herein may be removed and/or modified without departing from a scope of the multi-layer packaging material 100.

The multi-layer packaging material 100 comprises a cellulose-based material layer 101, for example, a paper-based layer, having a grammage from 60 to 90 g/m², e.g., of 70 g/m². The inner surface of the cellulose-based material layer 101 layer, which is facing the wrapped fatty product) has a PPS roughness value that may range from 0.9 to 1.8 µm, e.g., of 1.4 µm, and a COBB-60 (water absorption) index that ranges from 2-20 g/m², e.g., 10 g/m². The outer surface of the cellulose-based material layer 101, which is facing the vapour deposited metallization layer, has a PPS roughness value that may range between 0.9 to 4.5 µm, e.g., of 1.2 µm, and a COBB-60 index that ranges from 14-23 g/m², e.g., 16 g/m². This paper-based layer 101 provides a good balance between strength and flexibility and may comprise a latex-based coating layer (not shown in this figure) on both of its surfaces. These latex-based coating layers improve the smoothness and flexibility of both surfaces. The paper-based layer also may have a tensile strength of 7.5 Kg/15 mm.

In such embodiment, the multi-layer packaging material 100 comprises a primer coating layer 1021 (pre-metallization layer) that is made of a mixture of nitrocellulose, acrylic and polyurethane polymers in solvent medium or, alternatively, a mixture of acrylic emulsions and acrylic styrene polymeric dispersions. This primer coating layer 1021 facilitates the adhesion of the vacuum deposited metallization layer 103, provides an adequate flexibility, good adhesion between layers good printing properties with various inks, including the most common inks such as solvent inks and UV-curable flexo inks, an improved water and light barrier properties. Examples of the primer coating layer when it is made of a mixture of nitrocellulose, acrylic and polyurethane polymers in solvent medium can be KAO Chimigraf or BASF Acronal, among others. Examples of the primer coating layer when it is made of a mixture of acrylic emulsions and acrylic styrene polymeric dispersions can be EASTMEN Eastek, among others. The primer coating layer 1021 can be present in an amount from 0.6 to 1.2 g/m², e.g., of 1 g/m².

The multi-layer packaging material 100 further comprises the vacuum deposited metallization layer 103 with a thickness between 30-60 nm, and more preferably of 40 nm. In this case, the vacuum deposited aluminum layer 103 may be passivated with a layer of aluminum oxide of about 10-15 nm that is deposited over said aluminum layer and protects it from corrosion. Aluminum, in contact with air, may naturally become passivated, thus generating its aluminum oxide coating.

There is a post-metallization coating layer 104 deposited on top of the vacuum deposited metallization layer 103 that comprises a mixture of nitrocellulose, acrylic and polyurethane polymers in solvent medium. This mixture prepares the printing surface of the multi-layer packaging material 100 for depositing a printing layer and/or an overprint varnish layer (OPV), if needed.

The multi-layer packaging material 100 also comprises an intermediate coating layer 105 made of acrylic polymeric emulsions, preferably styrene acrylic polymeric emulsions, polyurethanes and/or sulfopolyesters and an inner coating layer 106 made of acrylic copolymeric emulsions.

This particular embodiment of the multi-layer packaging material 100 may have the following barrier properties:
It may present oil and grease barriers which have been proved to be effective over 24 hours tested using ASTM F119 test, a water barrier of 5 measured according to ISP 535 T-441 test at 1800 seconds, and a water vapour barrier (WVTR, at 38°C, 90% Relative Humidity) of 40 measured according to ASTM-E96 test.

Figure 2 shows a schematic representation of a multi-layer packaging material 100 for fatty products of Figure 1 but including a tie coating layer 107 and a barrier coating layer 108, according to another embodiment of the disclosure.

In such embodiment, the pre-metallization layer 102, instead of comprising the primer coating layer 1021, comprises a tie coating layer 107 that is made of sulfopolyesters or a mixture of elastomeric polyurethanes and nitrocellulose, and a barrier coating layer 108 comprising a polyvinyl alcohol (PVA) polymer. The tie coating layer 107 is arranged onto the cellulose-based material layer and the barrier coating layer 108 is arranged between the tie coating layer 107 and the vacuum deposited metallization layer 103. This multi-layer packaging material 100 presents improved oxygen and water vapour barrier properties with respect to the multi-layer packaging material 100 shown in Figure 1 due to the presence of the barrier coating layer 108. This allows to extend the shelf life of the fatty product to be wrapped while keeping it in better conditions, ensuring an optimal product condition for a longer time. The polyvinyl alcohol (PVA) polymer may be unmodified or modified PVA. By unmodified PVA is understood as a polymer with the repeating unit [CH₂CH(OH)]*ₙ* also referred to in the art simply as polyvinyl alcohol (PVA). Commercial examples of unmodified PVA include for instance Selvol^{™} from Sekisui or Poval^{™} grades from Kuraray. By "modified" PVA, it is meant PVA polymer which has been chemically modified, including PVA having another monomer (e.g. a polyvinyl alcohol copolymer) or another compound grafted thereto, or PVA resin which has been mixed with other components, e.g., with plasticizers. An example of modified PVA may be, e.g., a PVA copolymer such as ethylene vinyl alcohol (EVOH) copolymer; butanediol vinyl alcohol (BVOH) copolymer. A particular example of modified PVA may be hydrophobically modified PVA, which advantageously may offer high water resistance and strong oil and gas barriers e.g. toward oxygen, carbon dioxide and various aromas even at elevated relative humidity. This modified PVA may be commercially available, e.g., under the name Kuraray Exceval^{™} or Nichigo G-Polymer^{™} from Nippon Goshei.

While the tie coating layer 107 is to planarize the surface of the paper-based layer 101 and to facilitate the adhesion of the barrier coating layer, the barrier coating layer 108 improves the oxygen and water vapour barrier properties of the multi-layer packaging material 100, the tie coating layer 107 is also to prevent humidity to travel from the wrapped fatty product towards the barrier coating layer, since said humidity may degrade the PVA.

This particular embodiment of the multi-layer packaging material 100, having a barrier coating layer 108 in an amount of 1.4 g/m², may have the following barrier properties:
It may present oil and grease barriers which have been proved to be effective over 24 hours tested using ASTM F119 test, a water barrier of 5 measured according to ISP 535 T-441 test at 1800 seconds, a water vapour barrier (WVTR, at 38°C, 90% Relative Humidity) of 21 measured according to ASTM-E96 test and an oxygen barrier (OTR, at 23°C, 50% Relative Humidity) of 12 measured according to ASTM D3985 test. This same particular embodiment of the multi-layer packaging material 100, but having a barrier coating layer 108 in an amount of 2.2 g/m², may present these barrier properties:
It may present oil and grease barriers which have been proved to be effective over 24 hours tested using ASTM F119 test, a water barrier of 5 measured according to ISP 535 T-441 test at 1800 seconds, a water vapour barrier (WVTR, at 38°C, 90% Relative Humidity) of 21 measured according to ASTM-E96 test and an oxygen barrier (OTR, at 23°C, 50% Relative Humidity) of 4 measured according to ASTM D3985 test.

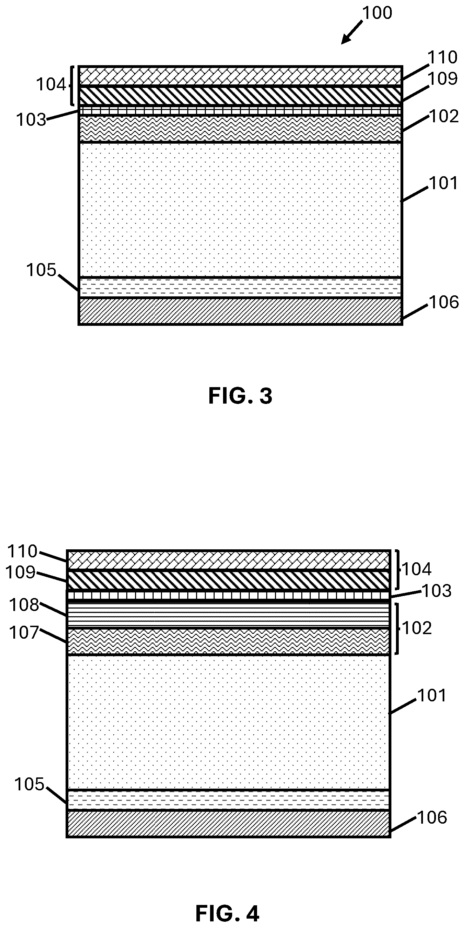

Figure 3 shows a schematic representation of the multi-layer packaging material for fatty products of Figure 1, including the primer coating layer and an inner and outer coating sublayers, according to another embodiment of the disclosure.

In such embodiment, the post-metallization coating layer 104 comprises an inner post-metallization coating sublayer 109 deposited onto the vacuum deposited metallization layer 103 and an outer post-metallization coating sublayer 110 deposited onto the inner post-metallization coating sublayer 109. The inner post-metallization coating sublayer 109 comprises a polyester solution, a mixture of elastomeric polyurethanes and nitrocellulose or acrylic copolymeric emulsions and the outer post-metallization coating sublayer 110 comprises a mixture of nitrocellulose, acrylic and polyurethane polymers in solvent medium. This post-metallization coating layer 104 improves the moisture and oil barrier properties obtained with the metallization of the previous layers and protects the vacuum deposited metallization layer 103.

This particular embodiment of the multi-layer packaging material 100, having an inner post-metallization coating sublayer 109 in an amount of 2 g/m², may present the following barrier properties:
It may present oil and grease barriers which have been proved to be effective over 24 hours tested using ASTM F119 test, a water barrier of 5 measured according to ISP 535 T-441 test at 1800 seconds, a water vapour barrier (WVTR, at 38°C, 90% Relative Humidity) of 25 measured according to ASTM-E96 test and an oxygen barrier (OTR, at 23°C, 50% Relative Humidity) of 300 measured according to ASTM D3985 test. Figure 4 shows a schematic representation of the multi-layer packaging material for fatty products of Figure 2, including a tie coating layer, a barrier coating layer, and an inner and outer coating sublayers, according to another embodiment of the disclosure.

In such embodiment, the pre-metallization layer 102 comprises the tie coating layer 107 that is made of sulfopolyesters or a mixture of elastomeric polyurethanes and nitrocellulose, and the barrier coating layer 108 comprising a polyvinyl alcohol (PVA) polymer. Besides, the post-metallization coating layer 104 comprises the inner post-metallization coating sublayer 109 deposited onto the vacuum deposited metallization layer 103 and the outer post-metallization coating sublayer 110 deposited onto the inner post-metallization coating sublayer 109.

This particular embodiment of the multi-layer packaging material 100, having a barrier coating layer 108 in an amount of 2.2 g/m² and an inner post-metallization coating sublayer 109 in an amount of 2 g/m², may have the following barrier properties:
It may present il and grease barriers which have been proved to be effective over 24 hours tested using ASTM F119 test, a water barrier of 5 measured according to ISP 535 T-441 test, a water vapour barrier (WVTR, at 38°C, 90% Relative Humidity) of 6 measured according to ASTM-E96 test and an oxygen barrier (OTR, at 23°C, 50% Relative Humidity) of 0.8 measured according to ASTM D3985 test.

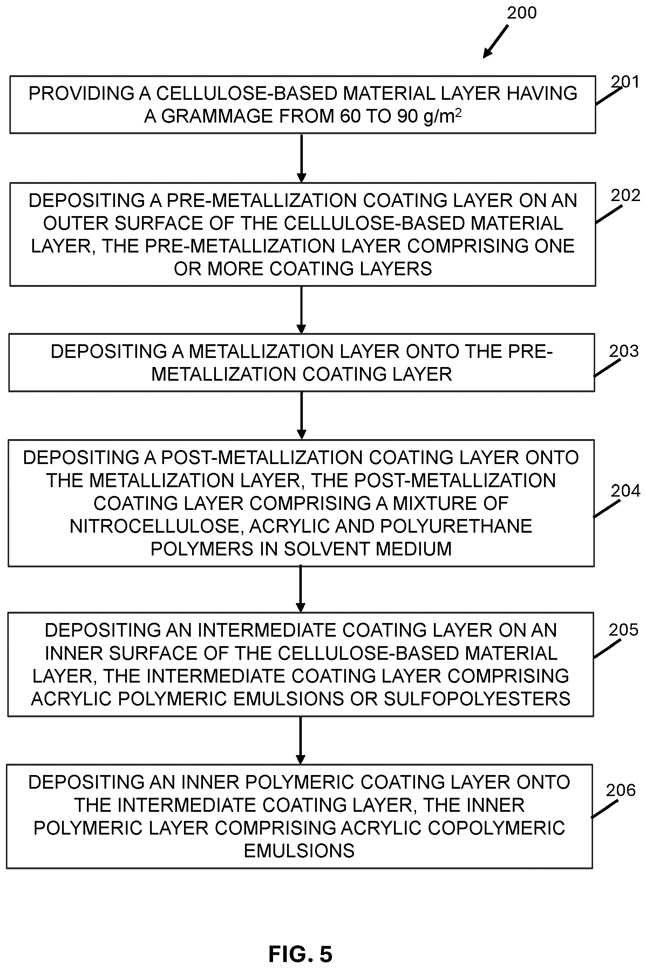

Figure 5 shows a flow diagram of a method 200 for manufacturing the multi-layer packaging material for fatty products, according to an embodiment of the disclosure.

At step 201 of the method 200, a cellulose-based material layer, for example, a paper-based layer, having a grammage comprised in the range from 60 to 90 g/m² is provided. This cellulose-based material layer will be selected so as to balance the mechanical resistance (tensile strength, elasticity, flexibility, etc.) and surface properties of the layer.

At step 202 of the method 200, a pre-metallization layer is deposited, by a dispersion coating technique, onto the cellulose-based material layer. This pre-metallization layer comprises one or more coating layers.

At step 203 of the method 200, a metallization layer is deposited, by a vacuum deposition technique, onto the intermediate layer. This metallization layer will be preferably made of aluminum, aluminum oxide and/or silicon oxide. For example, the vacuum deposition technique may be a physical vapor deposition process.

At step 204 of the method 200, a post-metallization layer is deposited, by a dispersion coating technique, onto the metallization layer, the post-metallization coating layer comprising a mixture of nitrocellulose, acrylic and polyurethane polymers in solvent medium.

At step 205 of the method 200, an intermediate layer is deposited, by a dispersion coating technique, on an inner surface of the cellulose-based material layer. The intermediate coating layer comprises acrylic polymeric emulsions, polyurethanes and/or sulfopolyesters.

At step 206 of the method 200, an inner polymeric coating layer is deposited, by a dispersion coating technique, onto the intermediate coating layer. The inner polymeric layer comprises acrylic copolymeric emulsions.

In some embodiments, the step of depositing a pre-metallization layer comprises depositing a primer layer on the outer surface of the cellulose-based material layer, the primer layer comprising a mixture of nitrocellulose, acrylic and polyurethane polymers in solvent medium or a mixture of acrylic emulsions and acrylic styrene polymeric dispersions.

In some embodiments, the step 202 of depositing a pre-metallization layer comprises:
depositing, by a dispersion coating technique, at least one tie layer comprising sulfopolyesters or a mixture of elastomeric polyurethanes and nitrocellulose, the at least one tie layer being deposited onto the cellulose-based material layer; and
depositing, by a dispersion coating technique, at least one barrier layer comprising a polyvinyl alcohol (PVA) polymer onto the at least one tie layer.

In some embodiments, the step 204 of depositing a post-metallization layer comprises:
depositing, by a dispersion coating technique, an inner post-metallization sublayer onto the metallization layer, the inner post-metallization sublayer comprising a polyester solution, a mixture of elastomeric polyurethanes and nitrocellulose or acrylic emulsions; and
depositing, by a dispersion coating technique, an outer post-metallization sublayer onto the inner post-metallization sublayer, the outer post-metallization sublayer comprising a mixture of nitrocellulose, acrylic polymers and polyurethanes in solvent medium.

The pre-metallization layers, including the tie layer, the primer layer and the barrier layer, the post-metallization layers, including the inner and outer sublayers, the intermediate layer and the inner layer may be typically deposited using dispersion coating techniques such as forward and reverse gravure coating, bar coating and curtain coating, among- others. Accordingly, such layers may also be referred to as dispersion coating layers in the multi-layer packaging material. Thanks to the use of polymer dispersion coating, the overall thickness of polymer material in the whole multi-layer packaging material is low when compared to the thickness of the cellulose-based material layer. Thus, the low thickness obtained by means of the dispersion coating of polymers avoids high cohesion and high adhesion of the polymer to the cellulose and therefore makes it possible for the multi-layer packaging material to be recycled using, e.g., conventional recycling paper techniques.

The overall thickness of the multi-layer packaging material herein may be adjusted by a person skilled in the art based on the intended purpose of the packaging material.

The multi-layer packaging material herein disclosed may have any thickness suitable for packaging materials. A person skilled in the art will be able to determine an appropriate thickness. Typically, however, if the packaging material is intended for use in packaging food products, the packaging material should be as thin as possible, while still ensuring safety and shelf life of the food product. For example, for food packaging it may have an overall thickness in the range of about 40 to 90 µm.

The present disclosure further relates to a wrapped fatty product comprising the package as described herein and a fatty product, also as described herein, wherein the package wraps the fatty product. Fatty products wrapped in such a package, such as butters of any type, including butters of various quality degrees such as premium butters, and salted or non-salted butters, advantageously have improved properties during storage, as their properties are maintained preventing or retarding ageing of the fatty products as evidenced by, e.g., a reduction of yellowing of the fatty product.

## Claims

1. A multi-layer packaging material (100) for wrapping fatty products comprising, from its outermost side to its innermost side, the following layers:
a post-metallization coating layer (104) comprising a mixture of nitrocellulose, acrylic and polyurethane polymers in solvent medium;
a vacuum deposited metallization layer (103);
a pre-metallization layer (102), comprising one or more coating layers;
a cellulose-based material layer (101) having a grammage from 60 to 90 g/m²;
an intermediate coating layer (105), the intermediate coating layer (105) comprising acrylic polymeric emulsions, polyurethanes and/or sulfopolyesters; and
an inner coating layer (106), the inner coating layer (106) comprising acrylic copolymeric emulsions.

2. The multi-layer packaging material (100) according to claim 1, wherein the pre-metallization layer (102) comprises at least one primer coating layer (1021) comprising a mixture of nitrocellulose, acrylic and polyurethane polymers in solvent medium or a mixture of acrylic emulsions and acrylic styrene polymeric dispersions, wherein, preferably, the at least one primer coating layer (1021) is present in an amount from 0.6 to 1.5 g/m² and more preferably, in an amount from 0.8 to 1.1 g/m².

3. The multi-layer packaging material (100) according to claim 1, wherein the pre-metallization layer (102) comprises:
at least one tie coating layer (107) comprising sulfopolyesters or a mixture of elastomeric polyurethanes and nitrocellulose, the at least one tie coating layer (107) being arranged onto the cellulose-based material layer, wherein, preferably, the at least one tie coating layer (107) is present in an amount from 0.3 to 2 g/m² and more preferably, in an amount from 0.5 to 1; and
at least one barrier coating layer (108) comprising a polyvinyl alcohol (PVA) polymer, the at least one barrier coating layer (108) being arranged between the tie coating layer (107) and the vacuum deposited metallization layer (103), wherein, preferably, the polyvinyl alcohol (PVA) polymer of the at least one barrier coating layer (108) is selected from: unmodified polyvinyl alcohol (PVA); ethylene vinyl alcohol (EVOH) copolymer; butanediol vinyl alcohol (BVOH) copolymer; and combinations thereof, and/or wherein, preferably, the at least one barrier coating layer (108) is present in an amount from 0.5 to 4 g/m² and more preferably, in an amount from 1.5 to 3 g/m².

4. The multi-layer packaging material (100) according to any one of the preceding claims, wherein the post-metallization coating layer (104) comprises an inner post-metallization coating sublayer (109) deposited onto the vacuum deposited metallization layer and an outer post-metallization coating sublayer (110) deposited onto the inner post-metallization coating sublayer (109), the inner post-metallization coating sublayer (109) comprising a polyester solution, a mixture of elastomeric polyurethanes and nitrocellulose or acrylic copolymeric emulsions and the outer post-metallization coating sublayer (110) comprising a mixture of nitrocellulose, acrylic and polyurethane polymers in solvent medium, wherein, preferably, the inner post-metallization coating sublayer (109) is present in an amount from 0.5 to 1.5 g/m² and/or the outer post-metallization coating sublayer (110) is present in an amount from 0.6 to 1.5 g/m² and more preferably, in an amount from 0.8 to 1.2 g/m².

5. The multi-layer packaging material (100) according to any one of the preceding claims, wherein the intermediate coating layer (105) is present in an amount from 1.5 to 4 g/m² and preferably in an amount from 2 to 3 g/m² and/or wherein the acrylic polymeric emulsions, if present, are selected from copolymeric acrylic emulsions, styrenated acrylic polymer emulsions; the polyurethane dispersions, if present, are selected from water-based polyurethane dispersions and the sulfopolyesters, if present, are selected from water-based sulfopolyester dispersions.

6. The multi-layer packaging material (100) according to any one of the preceding claims, wherein the inner coating layer (106) is present in an amount from 1 to 4 g/m² and preferably, in an amount from 2-3 g/m², and/or the inner coating layer (106) comprises an inorganic filler, wherein, preferably the inorganic filler is amorphous silica.

7. The multi-layer packaging material (100) according to claim 6, comprising amorpous silica, preferably wherein the amorphous silica has an average particle size from 1 to 6 micrometers and, preferably, from 2 to 5 micrometers.

8. The multi-layer packaging material (100) according to claims 7 or 8, wherein the weight ratio of acrylic copolymeric emulsions to inorganic filler ranges from 7:3 to 3:7, preferably from 5:5 to 3:7.

9. The multi-layer packaging material (100) according to any one of the preceding claims, wherein:
the surface of the cellulose-based material layer (101) on which the intermediate coating layer (105) is deposited has a Parker Print Surf (PPS) roughness value that ranges from 0.9 to 1.8 µm; and/or
the surface of the cellulose-based material layer (101) on which the pre-metallization layer (102) is deposited has a Parker Print Surf (PPS) roughness value that ranges from 0.9 to 4.5 µm.

10. The multi-layer packaging material (100) according to any one of the preceding claims, wherein the intermediate coating layer (105) comprises acrylic styrene polymeric emulsions, acrylic copolymer emulsions, and/or polyurethane dispersions.

11. A package for wrapping fatty products comprising the multi-layer packaging material (100) according to any one of claims 1 to 10.

12. A method (200) for manufacturing a muti-layer packaging material for wrapping fatty products, the method comprising the steps of:
providing (201) a cellulose-based material layer having a grammage from 60 to 90 g/m²;
depositing (202), by a dispersion coating technique, a pre-metallization layer on an outer surface of the cellulose-based material layer, the pre-metallization layer comprising one or more coating layers;
depositing (203), by a vacuum deposition technique, a metallization layer onto the pre-metallization layer;
depositing (204), by a dispersion coating technique, a post-metallization coating layer onto the metallization layer, the post-metallization coating layer comprising a mixture of nitrocellulose, acrylic and polyurethane polymers in solvent medium;
depositing (205), by a dispersion coating technique, an intermediate coating layer on an inner surface of the cellulose-based material layer, the intermediate coating layer comprising acrylic polymeric emulsions or sulfopolyesters; and
depositing (206), by a dispersion coating technique, an inner polymeric coating layer onto the intermediate coating layer, the inner polymeric layer comprising acrylic copolymeric emulsions.

13. The method (200) according to claim 12, wherein depositing (202) a pre-metallization layer comprises depositing, by a dispersion coating technique, at least one primer layer on the outer surface of the cellulose-based material layer, the at least one primer layer comprising a mixture of nitrocellulose, acrylic and polyurethane polymers in solvent medium or a mixture of acrylic emulsions and acrylic styrene polymeric dispersions.

14. The method (200) according to claim 12, wherein depositing (202) a pre-metallization layer comprises:
depositing, by a dispersion coating technique, at least one tie layer comprising sulfopolyesters or a mixture of elastomeric polyurethanes and nitrocellulose, the tie coating layer being deposited onto the cellulose-based material layer; and
depositing, by a dispersion coating technique, at least one barrier coating layer comprising a polyvinyl alcohol (PVA) polymer onto the at least one tie coating layer.

15. The method (200) according to any one of claims 12-14, wherein the step of depositing (204) a post-metallization coating layer comprises:
depositing, by a dispersion coating technique, an inner post-metallization sublayer onto the metallization layer, the inner post-metallization sublayer comprising a polyester solution, a mixture of elastomeric polyurethanes and nitrocellulose or a mixture of acrylic emulsions; and
depositing, by a dispersion coating technique, an outer post-metallization sublayer onto the inner post-metallization sublayer, the outer post-metallization sublayer comprising a mixture of nitrocellulose, acrylic polymers and polyurethanes in solvent medium.

16. A wrapped fatty product comprising the package of claim 12 and a fatty product, wherein the package wraps the fatty product.
